Europäisches Patentamt

European Patent Office

Office européen des brevets

(11) Publication number: **0 078 857**
**B1**

# EUROPEAN PATENT SPECIFICATION

(45) Date of publication of patent specification: 30.04.86

(21) Application number: 81109520.7

(22) Date of filing: 05.11.81

(51) Int. Cl.⁴: **H 04 L 27/04, H 03 C 1/00, H 03 B 21/02**

(54) **Digital amplitude modulating circuitry.**

(43) Date of publication of application:
**18.05.83 Bulletin 83/20**

(45) Publication of the grant of the patent:
**30.04.86 Bulletin 86/18**

(84) Designated Contracting States:
**DE FR GB**

(56) References cited:
**DE-A-2 200 374**
**US-A-3 654 450**
**US-A-3 749 843**

(73) Proprietor: **Hewlett-Packard Company**
**Mail Stop 20 B-O 3000 Hanover Street**
**Palo Alto California 94304 (US)**

(72) Inventor: **Kovalick, Al**
**2650 Webster Court**
**Santa Clara, CA 95051 (US)**
Inventor: **Hassun, Rolly**
**875 Regent Court**
**San Carlos 94070 (US)**

(74) Representative: **Schulte, Knud, Dipl.-Ing.**
**c/o Hewlett-Packard GmbH Europ. Patent- und**
**Lizenzabteilung Postfach 1430 Herrenberger**
**Strasse 130**
**D-7030 Böblingen (DE)**

Courier Press, Leamington Spa, England.

## Description

This invention relates to a digital amplitude modulating circuitry according to the preamble of claim 1.

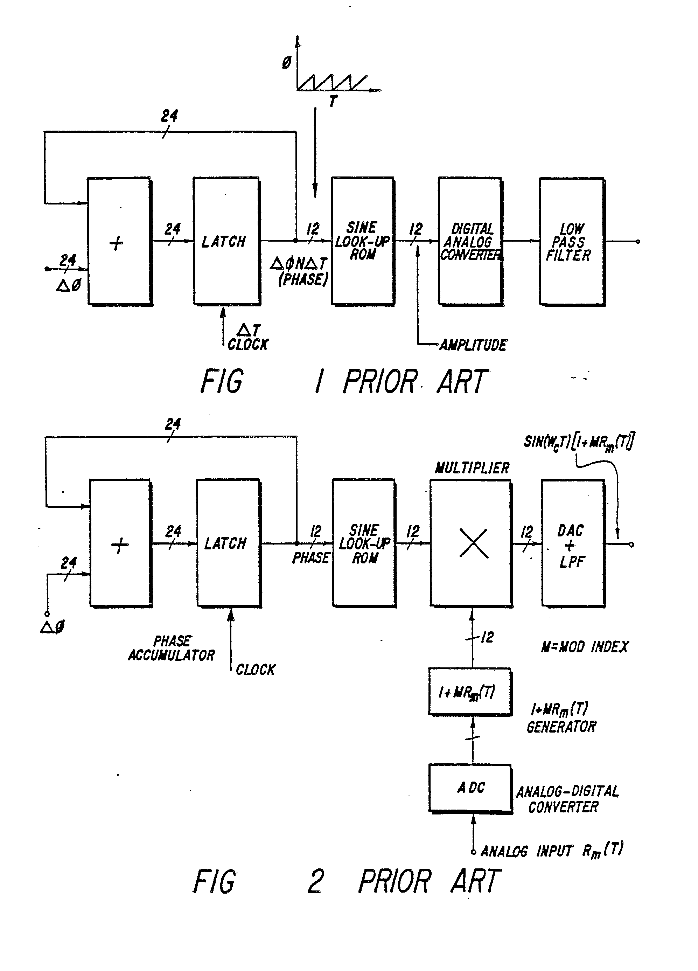

A circuitry for modulating the amplitude of sine wave carrier signals as shown in figure 2 is known from US patent 3 654 450. The circuitry was developed from a synthesizer for frequency and phase modulation purposes, as shown in figure 1.

In the circuitry of figure 2, the carrier frequency information represented by the term SIN Wc · T is derived from a phase-to-amplitude converter including a read-only-memory. A modulating signal source provides signals according to the term 1+MRm(T), where M is the modulation index and Rm(T) represents the modulating amplitude. The amplitude modulation, AM hereafter, is provided by a multiplier and its speed limits the maximum carrier frequency. Furthermore, to reduce the spurious signals that result from too coarse an amplitude resolution at least ten bits are typically needed thereby requiring a 10×10 bit type multiplier. State-of-the-art multipliers of this size are complex and require about at least 90 ns per multiplication. The addition of the multiplier and of the generator for providing signals representing the term 1+MRm(T) approximately double the complexity of the synthesizer.

In view of this prior art a major object of the invention is to improve a digital amplitude modulating circuitry of the kind described in the preamble of claim 1 so that its design is simplified and it allows the amplitude modulation of sinusoidal signals with higher carrier frequencies.

This object is solved according to the characterized clause of claim 1. An underlying concept of this invention is to digitally modulate the amplitude of an input signal in the phase domain by the use of an adder so that no multiplication is required.

A preferred embodiment of the invention will be explained together with prior art with reference to the following drawings:

Figure 1 is a block diagram of a prior art digital synthesizer

Figure 2 is a block diagram of a prior art digital synthesizer with amplitude modulation.

Figure 3 is a block diagram of a preferred digital amplitude modulator built in accordance with the invention.

Figure 4 is a vector diagram illustrating the amplitude modulation method.

Figure 5 shows simplified spectra of a phase-modulated signal and of a pure amplitude-modulated signal.

Figure 6 shows frequency spectra of amplitude modulated signals and of phase modulated signals present in the operation of the preferred embodiment.

Subsequently the theory behind the inventive concept of amplitude modulation in the phase domain using an adding technique is explained:

It is possible to modulate a carrier frequency signal in such a way that both amplitude and phase modulation result. The aim is to eliminate phase modulation signal components so that only AM results.

To understand how this is achieved, consider the function,

$$SIN \ (W_cT+X) \tag{1}$$

where Wc is the carrier radial frequency and X is a phase offset. Let the phase offset be a continuous function of time represented by:

$$X(T)=ARC \ COS[0.5 \ (1+MRm(t)] \tag{2}$$

where Rm(T) is the modulating amplitude and M is the modulation index. Now, using X(T), generate two phase-modulated waves G1(T) and G2(T):

$$G1(T)=SIN(W_cT+X(T))=SIN(W_cT)\left[\frac{1}{2}+\frac{MRm(T)}{2}\right]+COS(W_cT) \cdot SIN[X(T)] \tag{3}$$

$$G2(T)=SIN(W_cT-X(T))=SIN(W_cT)\left[\frac{1}{2}+\frac{MRm(T)}{2}\right]-COS(W_cT) \cdot SIN[X(T)] \tag{4}$$

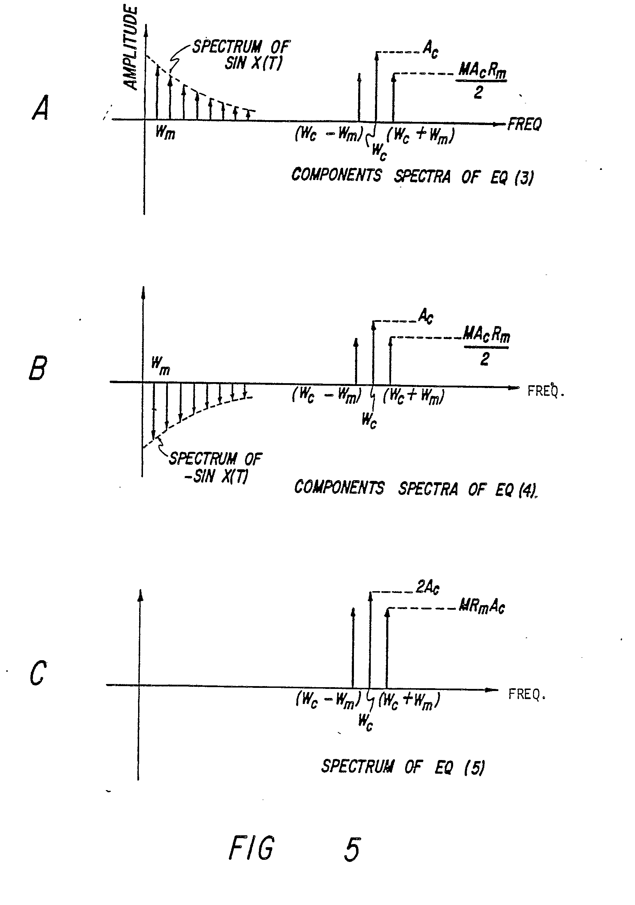

In Figure 5, drawing A shows components spectra for equation (3) and drawing B shows components spectra for equation (4). For clarity, the spectrum of

$$COS(W_cT) \cdot SIN[X(T)]$$

has been shifted to the origin in Figures 5A and 5B. The

$$COS(W_cT) \cdot SIN[X(T)]$$

term actually centers on the carrier frequency Wc. To clarify the picture, only the base term SIN[X(T)] is shown. The COS(WcT) up translates the SIN[X(T)] term around the carrier frequency.

The sum of the two modulated waves G1(T) and G2(T) reveals an interesting property, as shown in Figure 5C:

$$G1(T)+G2(T)=SIN(W_cT) \cdot (1+MRm(T)). \tag{5}$$

The result is the traditional form for pure amplitude modulation. The above is true for continuous analog signals.

Using digital techniques, signals according to equation (5) are generated with the addition of terms G3(T):

$$G1(T)+G2(T)=SIN(WcT)(1+MRm(T))+G3(T)$$

$$(6)$$

These terms are easily filtered by an output low-pass filter (LPF), reducing equation (6) to equation (5).

To generate (6) consider function S(T) defined as a square wave with a positive amplitude, say +1, and a negative amplitude, say −1. The repetition rate is Fclock/2. Using S(T), equations (3) and (4) can be represented in a combined form by using trigonometric identities, and equation (7) is obtained:

$$SIN(WcT+S(T)\cdot X(T))=SIN(WcT)COS(X(T)$$
$$+COS(WcT)S(T)SIN[X(T))]$$

$$(7)$$

The right-most term, COS(WcT)S(T)SIN[X(T)], has a very complex frequency spectrum. This is similar to the undesired term appearing in equations (3) and (4). However, the S(T) square wave causes this PM term to be translated up in frequency. Thus, the first undesired spectral lines occur around Fclock/2. If the output low-pass filter LPF is designed to reject these components and all those higher in frequency, then equation (7) reduces to:

$$SIN(WcT+S(T)X(T))_{LPF}=SIN(WcT)(1+MRm(T))$$

$$(8)$$

Indeed as Fclock approaches infinity, the COS(WcT)S(T)SIN[X(T)] term does also, and the only remaining signal is the AM spectrum.

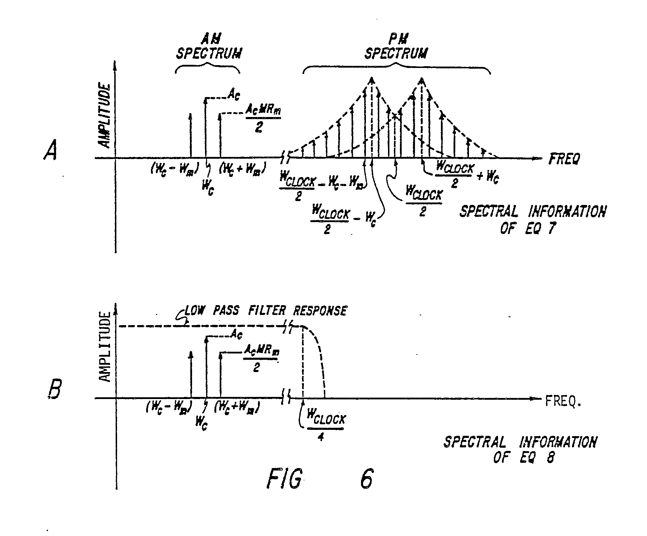

See Figure 6 for spectral information of equations (7) and (8). Notice that equation (8) is equivalent to equation (5) which was obtained for continuous signals. Equation (7) can be visualized by reference to Figure 4. The carrier frequency is represented by a rotating vector V2. Each cycle of the digital clock causes either X(T) or −X(T) to phase modulate the carrier. The results are V1 and V3 respectively. This causes both AM and PM. As already mentioned, the PM component is filtered by the output LPF. The M results due to the resultant vector (V2=V1+V3) being projected onto the X axis with vector V2 rotating at the carrier frequency. As the modulating wave Rm(T) varies, the X(T) term is of the correct magnitude so that the V2 carrier amplitude changes proportionally to Rm(T).

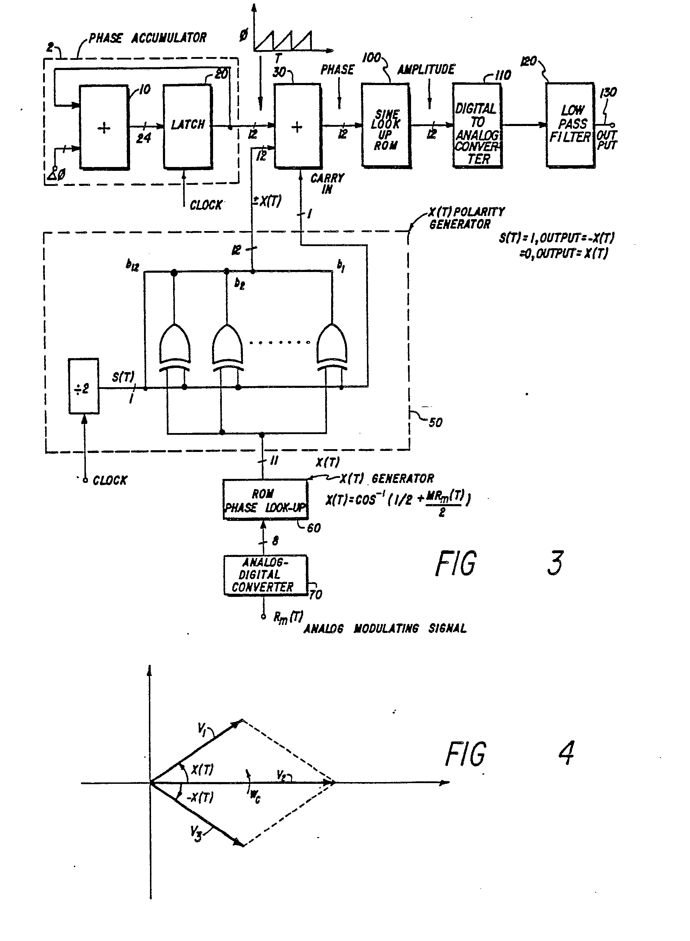

Referring to Figure 3, a phase accumulator 20 comprised of an adder 10 and a latch 20 accumulates a linearly increasing phase. A differential phase Δφ value determines the output carrier frequency. An external controller provides the phase information Δφ and the clock information T. Another input to the adder 30 is derived from an AM phase generator. This phase generator is comprised of a polarity generator 50, an amplitude-to-phase conversion ROM 60, and an A/D converter 70. The contents of the ROM 60 for AM with a 100% modulation index is given in Table 1 below. The ROM 60 stores 256 words of 11 bits each, and the given values are in octal format with phase values φ in radians. For example, the octal digits 2777 means π radians.

TABLE

Byte location decimal:

| 1—64 | 65—128 | 129—192 | 193—256 |
|---|---|---|---|
| 1241 | 13 | 1264 | 1777 |
| 1230 | 27 | 1275 | 1777 |
| 1216 | 42 | 1306 | 1777 |
| 1205 | 55 | 1317 | 1776 |
| 1173 | 71 | 1330 | 1775 |
| 1162 | 104 | 1340 | 1774 |
| 1150 | 117 | 1351 | 1773 |
| 1136 | 132 | 1362 | 1771 |
| 1124 | 146 | 1372 | 1770 |
| 1113 | 161 | 1403 | 1766 |
| 1101 | 174 | 1413 | 1764 |
| 1067 | 207 | 1423 | 1761 |
| 1055 | 223 | 1433 | 1757 |
| 1042 | 236 | 1443 | 1754 |
| 1030 | 251 | 1453 | 1752 |
| 1016 | 264 | 1463 | 1747 |
| 1004 | 300 | 1473 | 1744 |
| 772 | 313 | 1502 | 1740 |
| 757 | 326 | 1512 | 1735 |
| 745 | 341 | 1521 | 1731 |
| 732 | 354 | 1530 | 1725 |
| 720 | 367 | 1540 | 1721 |
| 705 | 402 | 1547 | 1715 |
| 673 | 415 | 1555 | 1711 |
| 660 | 430 | 1564 | 1704 |
| 646 | 443 | 1573 | 1677 |
| 633 | 456 | 1601 | 1672 |

## TABLE continued

Byte location decimal:

| 1—64 | 65—128 | 129—192 | 193—256 |
|---|---|---|---|
| 620 | 471 | 1610 | 1665 |
| 606 | 504 | 1616 | 1660 |
| 573 | 517 | 1624 | 1653 |
| 560 | 532 | 1632 | 1645 |
| 545 | 545 | 1640 | 1640 |
| 532 | 560 | 1645 | 1632 |
| 517 | 573 | 1653 | 1624 |
| 504 | 606 | 1660 | 1616 |
| 471 | 620 | 1665 | 1610 |
| 456 | 633 | 1672 | 1601 |
| 443 | 646 | 1677 | 1573 |
| 430 | 660 | 1704 | 1564 |
| 415 | 673 | 1711 | 1555 |
| 402 | 705 | 1715 | 1547 |
| 367 | 720 | 1721 | 1540 |
| 354 | 732 | 1725 | 1530 |
| 341 | 745 | 1731 | 1521 |
| 326 | 757 | 1735 | 1512 |
| 313 | 772 | 1740 | 1502 |
| 300 | 1004 | 1744 | 1473 |
| 264 | 1016 | 1747 | 1463 |
| 251 | 1030 | 1752 | 1453 |
| 236 | 1042 | 1754 | 1443 |
| 223 | 1055 | 1757 | 1433 |
| 207 | 1067 | 1761 | 1423 |
| 174 | 1101 | 1764 | 1413 |
| 161 | 1113 | 1766 | 1403 |
| 146 | 1124 | 1770 | 1372 |
| 132 | 1136 | 1771 | 1362 |
| 117 | 1150 | 1773 | 1351 |

## TABLE continued

Byte location decimal:

| 1—64 | 65—128 | 129—192 | 193—256 |
|---|---|---|---|
| 104 | 1162 | 1774 | 1340 |
| 71 | 1173 | 1775 | 1330 |
| 55 | 1205 | 1776 | 1317 |
| 42 | 1216 | 1777 | 1306 |
| 27 | 1230 | 1777 | 1275 |
| 13 | 1241 | 1777 | 1264 |
| 0 | 1252 | 2000 | 1252 |

A random modulating wave, Rm(T) with a maximum frequency of Fclock/4, is first digitized by the A/D-converter 70. This digital value addresses the ROM 60 to derive phase information therefrom. The output signal from the ROM is then fed to the polarity generator 50.

The purpose of the polarity generator 50 is to supply an output signal that is X(T) on clock pulse N and −X(T) on clock pulse N+1 and so on. The sequence of X(T), −X(T), X(T) ... is the input signal to phase adder 30. This is where the phase value modulates the carrier signal. The output of the phase adder 30 is then converted into an amplitude by a sine function ROM 100, a D/A converter 110 and a low-pass filter 120. The output 130 of the low-pass filter 120 is the desired amplitude modulated carrier signal.

If the modulation index, M is to be variable, then the ROM 60 has to be a RAM instead of a ROM. The RAM contents are updated each time a new modulation index is requested. Since the synthesizer has a controller, which provides the $\Delta\phi$ and clock inputs, this same controller is used to calculate the RAM contents. If M is a constant, the ROM contents are fixed.

**Claims**

1. Digital amplitude modulating circuitry for sinusoidal carrier frequency signals, including

a) a digital phase accumulator (2) for providing a digital phase signal in response to a carrier frequency signal to be modulated,

b) digital modulating and phase-to-amplitude conversion means, comprising a sine function memory (100) and having a first input connected to the digital phase accumulator and having a second input for receiving a digital modulating signal,

c) a digital-to-analog converter (110) connected to an output of the digital modulating and phase-to-amplitude conversion means, and

d) a low-pass filter connected to the digital-to-analog converter and forming the output of the circuitry, characterized in that

e) the digital modulating and phase-to-amplitude conversion means further comprises an adder (30) having

— a first input coupled to receive the digital phase signal,
— a second input coupled to a polarity generator (50) which is coupled to receive the digital modulating signal and to deliver to the adder an alternately polarized digital modulating signal, and
— an output to deliver a digital phase modulated signal,

f) the sine function memory (100) is coupled to receive from the adder the digital phase modulated signal to deliver a digital signal representing a sinusoidal carrier frequency signal with AM and PM information,

g) the digital-to-analog converter is connected to the sine function memory, and

h) the low-pass filter is coupled to receive from the digital-to-analog converter (110) a carrier frequency signal containing lower frequency amplitude modulated spectral components and higher frequency phase modulated spectral components and to deliver at its output the sinusoidal amplitude modulated carrier frequency signal without substantial phase modulated spectral components.

2. Circuitry as in claim 1, characterized in that a phase converting memory (60) is connected to the polarity generator (50) to provide a signal according to the formula

$$X(T)=ARCCOS \ (0{,}5+0{,}5 \ MR_m(T))$$

in response to a modulating signal, where $R_m(T)$ is the modulating amplitude and M is the modulation index.

3. Circuitry as in claim 2, characterized in that an analog-to-digital converter (70) is connected to the phase converting memory (60) in order to convert analog modulating signals into digital modulating signals.

4. Circuitry as in any of the preceding claims, characterized in that the phase accumulator (2) contains in a known per se manner an adder (10) with a first input to receive carrier frequency signals to be amplitude modulated, and a clocked latch (20) with a feedback connection from its output to a second adder input to deliver at its output digital phase signals.

5. Circuitry as in any of the preceding claims, characterized in that the polarity generator (50) includes a network of logic gates connected to deliver a periodic square wave switching signal with alternating positive and negative amplitudes at half the repetition rate of the clock signal supplied to the latch of the phase accumulator (2).

6. Circuitry as in claim 1, characterized in that the sine function memory (100) is a read-only memory.

7. Circuitry as in claim 1, characterized in that the sine function memory (100) is a random-access memory.

**Revendications**

1. Circuit de modulation numérique d'amplitude pour les signaux sinusoîdaux à fréquence porteuse, comprenant

a) un accumulateur de phase numérique (2) servant à délivrer un signal de phase numérique en réponse à un signal à fréquence porteuse devant être modulé,

b) des moyens de modulation numérique et de conversion phase-amplitude, comportant une mémoire (100) d'une fonction sinusoîdale et possédant une première entrée raccordée à l'accumulateur de phase numérique et à une seconde entrée destinée à recevoir un signal de modulation numérique,

c) un convertisseur numérique/analogique (110) raccordé à une sortie des moyens de modulation numérique et de conversion en phase-amplitude, et

d) un filtre passe-bas raccordé au convertisseur numérique/analogique et formant la sortie du circuit, caractérisé en ce que

e) les moyens de modulation numérique et de conversion phase-amplitude comprennent en outre un additionneur (30) possédant

— une première entrée raccordée de manière à recevoir le signal de phase numérique,
— une seconde entrée raccordée à une générateur de polarité (50), qui est accouplé de manière à recevoir le signal de modulation numérique et à délivrer à l'additionneur un signal de modulation numérique polarisé en alternance, et
— une sortie servant à délivrer un signal de phase numérique modulé,

f) la mémoire (100) de la fonction sinusoîdale est raccordée de manière à recevoir de l'additionneur le signal de phase numérique modulé de manière à délivrer un signal numérique représentant un signal à fréquence porteuse sinusoîdale comportant une information de modulation d'amplitude et une information de modulation d'impulsions,

g) le convertisseur numérique/analogique est raccordé à la mémoire de la fonction sinusoîdale, et

h) le filtre passe-bas est raccordé de manière à recevoir, de la part du convertisseur numérique/analogique (110), un signal à fréquence porteuse contenant des composantes spectrales modulées en amplitude, possédant des fréquences inférieures, et des composantes spectrales modulées du point de vue de la phase, possédant des fréquences supérieures, et à délivrer sur sa sortie le signal sinusoîdal à fréquence porteuse modulé en amplitude, sans composantes substantielles spectrales modulées du point de vue de la phase.

2. Circuit selon la revendication 1, caractérisé en ce qu'une mémoire de conversion de phase (60) est raccordée au générateur de polarités (50) de manière à délivrer un signal répondant à la formule

$$X(T) = \text{ARCCOS } (0,5 + 0,5 \ MR_m(T))$$

en réponse à un signal de modulation, $R_m(T)$ étant l'amplitude de modulation et M l'indice de modulation.

3. Circuit selon la revendication 2, caractérisé en ce qu'un convertisseur analogique/numérique (70) est raccordé à la mémoire de conversion de phase (60) de manière à convertir les signaux de modulation analogique en signaux de modulation numérique.

4. Circuit selon l'une quelconque des revendications précédentes, caractérisé en ce que l'accumulateur de phase (2) contient, d'une manière connue en soi, un additionneur (10) muni d'une première entrée servant à recevoir les signaux à fréquence porteuse devant être modulés en amplitude, et une bascule bistable (20) commandée de façon cadencée et comportant une boucle de réaction branchée depuis sa sortie jusqu'à l'entrée d'un second additionneur et servant à délivrer à sa sortie, des signaux de phase numériques.

5. Circuit selon l'une des revendications précédentes, caractérisé en ce que le générateur de polarités (50) comprend un réseau de portes logique agencées de façon à délivrer un signal de commutation périodique rectangulaire d'amplitudes positives et négatives alternées à une fréquence de récurrence moitié de celle du signal d'horloge délivré à la bascule bistable de l'accumulateur de phase (2).

6. Circuit selon la revendication 1, caractérisé en ce que la mémoire (100) de la fonction sinusoïdale est une mémoire morte.

7. Circuit selon la revendication 1, caractérisé en ce que la mémoire (100) de la fonction sinusoïdale est une mémoire vive.

**Patentansprüche**

1. Schaltungsanordnung zur digitalen Amplitudenmodulation sinusförmiger Trägerfrequenzsignale mit·
a) einem digitalen Phasenakkumulator (2) zum Erzeugen eines digitalen Phasensignals in Abhängigkeit von einem zu modulierenden Trägerfrequenzsignal,
b) eine digitale Modulations- und Phasen/Amplitudenwandlereinrichtung mit einem Sinusfunktionsspeicher (100), mit einem mit dem digitalen Phasenakkumulator verbunden ersten Eingang, und einem zweiten Eingang zum Empfang eines digitalen Modulationssignals,
c) einem mit einem Ausgang der digitalen Phasen/Amplitudenwandlereinrichtung verbundenen Digital/Analogwandler (110), und
d) einem mit dem Digital/Analogwandler verbundenen Tiefpaßfilter, welches den Ausgang der Schaltung bildet, dadurch gekennzeichnet, daß

e) die digitale Modulations; und Phasen/Amplitudenwandlereinrichtung einen Addierer (30) umfaßt mit

— einem ersten Eingang zum Empfang des digitalen Phasensignals,
— einem zweiten Eingang, der mit einem Polaritätsgenerator (50) verbunden ist, welcher das digitale Modulationssignals empfängt und an den Addierer ein alternierend polarisiertes digitales Modulationssignal liefert, und
— einem Ausgang zur Abgabe eines digitalen phasenmodulierten Signals,

f) der Sinusfunktionsspeicher (100) mit dem Addierer verbunden ist zum Empfangen des digitalen phasenmodulierten Signals, um ein digitales Signal abzugeben, welches ein sinusförmiges Trägerfrequenzsignal mit AM und PM - Informationsgehalt darstellt,

g) der Digital/Analogwandler mit dem Sinusfunctionsspeicher verbunden ist, und

h) das Tiefpaßfilter mit dem Digital/Analogwandler (110) zum Empfangen eines Trägerfrequenzsignals verbunden ist, welches niederfrequente amplitudenmodulierte Spektralkomponenten und höberfrequente phasenmodulierte Spektralkomponenten umfaßt, und zur Abgabe des sinusförmigen amplitudenmodulierten Trägerfrequenzssignals ohne wesentliche phasenmodulierte Spektralkomponenten an seinem Ausgang.

2. Schaltungsanordnung nach Anspruch 1, dadurch gekennzeichnet, daß ein Phasenumwandlungsspeicher (60) mit dem Polaritätsgenerator (50) verbunden ist zur Abgabe eines Signals gemäß der Formel

$$X(T) = \text{ARCCOS } (0,5 + 0,5 \ MR_m(T))$$

in Abhängigkeit von einem Modulationssignal, wobei $R_m(T)$ die Modulationsamplitude und M der Modulationsindex ist.

3. Schaltungsanordnung nach Anspruch 2, dadurch gekennzeichnet, daß ein Analog/Digitalwandler (70) mit dem Phasenumwandlungsspeicher (60) zum Umwandlung analoger Modulationssignale in digitale Modulationssignale verbunden ist.

4. Schaltungsanordnung nach einem der vorhergehenden Ansprüche, dadurch gekennzeichnet, daß der Phasenakkumulator (2) in an sich bekannter Weise einen Addierer (10) enthält, mit einem ersten Eingang zum Empfang von Trägerfrequenzsignalen, die amplitudenmoduliert werden sollen, und eine getaktete Halteschaltung (20) mit einer Rückkopplungsverbindung von ihrem Ausgang zu einem zweiten Eingang des Addierers zum Abgeben digitaler Phasensignale am Ausgang.

5. Schaltungsanordnung nach einem der vorhergehenden Ansprüche, dadurch gekennzeichnet, daß der Polaritätsgenerator (50) ein Netzwerk von Logikgattern umfaßt, welche ein periodisches Rechteckwellenschaltsignal mit sich abwechselnden positiven und negativen Amplituden mit der halben Wiederholungsfrequenz des Taktsignals abgibt, welches der Halteschaltung des Phasenakkumulators (2) zugeführt wird.

6. Schaltungsanordnung nach Anspruch 1, dadurch gekennzeichnet, daß der Sinusfunktionsspeicher (100) ein Auslesespeicher ist.

7. Schaltungsanordnung nach Anspruch 1, dadurch gekennzeichnet, daß der Sinusfunktionsspeicher (100) ein Speicher mit wahlfreiem Zugriff ist.

FIG 1 PRIOR ART

FIG 2 PRIOR ART

FIG 3

FIG 4

FIG 5

FIG 6